# FASCICULE DE BREVET EUROPEEN

(11) **EP 3 664 293 B1**
(45) Date de publication et mention de la délivrance du brevet: **24.03.2021**
(21) Numéro de dépôt: 19212899.9
(22) Date de dépôt: 02.12.2019
(51) Int. Cl.: H03K 17/0812, H03K 17/082, H03K 17/06

(54) **PROCÉDÉ DE PILOTAGE D'UN COMPOSANT À GRILLE ISOLÉE ET CIRCUIT DE PILOTAGE CORRESPONDANT**
VERFAHREN ZUR ANSTEUERUNG EINES BAUTEILS MIT ISOLIERTEM GATE UND ENTSPRECHENDE TREIBERSCHALTUNG
METHOD FOR DRIVING AN INSULATED GATE COMPONENT AND CORRESPONDING DRIVING CIRCUIT

(30) Priorité: 03.12.2018 FR 1872228
(43) Date de publication de la demande: 10.06.2020
(73) Titulaire: ALSTOM Transport Technologies, 93400 Saint-Ouen-sur Seine (FR)
(72) Inventeur: ANDRIANOELISON, Florent, 65800 AUREILHAN (FR)
(74) Mandataire: Lavoix

(56) Documents cités:
- EP-A2- 0 369 448
- DE-T5-112016 006 141

## Description

L'invention a pour domaine celui des procédés de pilotage d'un composant à grille isolée propre à basculer entre un état passant et un état bloquant, du type comportant les étapes consistant à :
- amorcer l'état passant par application d'une première tension, ladite première tension étant une tension positive, supérieure à un seuil de conduction du composant et appliquée pendant une durée d'amorçage ; puis,
- maintenir l'état passant par application d'une seconde tension, ladite seconde tension étant une tension positive supérieure à la première tension.

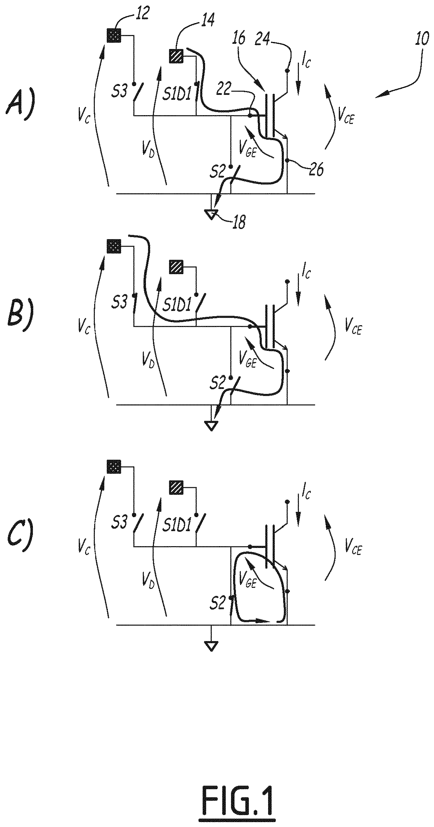

Le document US 2010/0148846 A1 décrit un tel procédé mis en œuvre dans un circuit 10 représenté schématiquement sur les figures 1A à 1C.

Le circuit 10 comporte un transistor IGBT 16 dont la grille 22 est connectée :
- via un premier interrupteur S1D1, à un premier point 14 porté à un potentiel tel que la différence de potentiels entre ce premier point et un point de masse 18 corresponde à la première tension, VD;
- via un second interrupteur S3, à un second point 12 porté à un potentiel tel que la différence de potentiels entre ce premier point et le point de masse 18 corresponde à la seconde tension, VC ; et,
- via un troisième interrupteur S2, au point de masse 18.

Par ailleurs, l'émetteur 26 du transistor 16 est connecté au point de masse 18 et le collecteur 24 du transistor 16 à une charge (non représentée sur les figures).

Dans l'étape d'amorçage du basculement du transistor dans l'état passant (« ON »), représentée à la figure 1A, les interrupteurs S3 et S2 sont ouverts, tandis que l'interrupteur S1D1 est fermé, de sorte que la tension VGE entre l'émetteur 26 et la grille 22 soit égale à la première tension VD.

Dans l'étape de maintien du transistor dans l'état passant (« ON »), représentée à la figure 1B, les interrupteurs S1D1 et S2 sont ouverts, tandis que l'interrupteur S3 est fermé, de sorte que la tension VGE entre l'émetteur 26 et la grille 22 soit égale à la seconde tension VC.

Dans une étape de basculement du transistor dans l'état bloquant (« OFF »), représentée à la figure 1C, les interrupteurs S1D1 et S3 sont ouverts, tandis que l'interrupteur S2 est fermé, de sorte que la tension VGE entre l'émetteur 26 et la grille 22 soit nulle.

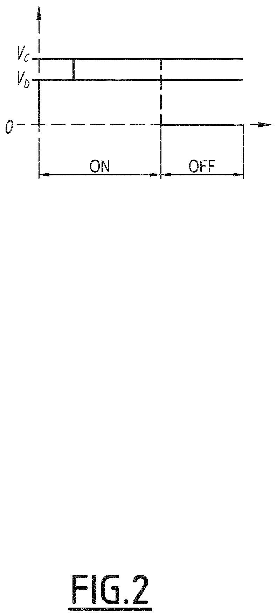

La figure 2 résume ces différentes étapes de pilotage du transistor 16 en représentant la tension VGE au cours du temps. On observe sur la figure 2 que pour établir l'état passant, la première tension est d'abord appliquée sur la grille du transistor 16, pendant une période, dite d'amorçage, qui est courte devant la période totale durant laquelle le transistor est maintenu dans l'état passant. En d'autres termes, la période durant laquelle la première tension est appliquée sur la grille du transistor 16 est courte devant la période pendant laquelle la seconde tension est appliquée sur la grille du transistor 16. Pour établir l'état bloquant du transistor 16, on observe sur la figure 2 que la tension VGE est annulée.

Cette solution est avantageuse mais est sensible aux perturbations, notamment les perturbations risquant de conduire au basculement du composant de puissance inopinément de l'état bloquant à l'état passant.

Par ailleurs, le document EP 0 369 448 A2 ou le document DE 11 2016 006141 prévoit que pour basculer un transistor de puissance dans l'état passant, les interrupteurs de son circuit de contrôle sont commandés pour appliquer une première tension entre sa grille et son émetteur ; et que pour basculer ce même transistor dans l'état bloquant, les interrupteurs sont commandés pour appliquer une seconde tension entre sa grille et son émetteur, la première tension étant strictement positive et seconde tensions étant strictement négative.

Le but de la présente invention est de résoudre ce problème.

Pour cela, l'invention a pour objet un procédé de pilotage d'un composant de puissance à grille isolé du type transistor, un circuit de pilotage d'un composant de puissance à grille isolé du type transistor et un dispositif de puissance selon les revendications annexées.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :
[Fig 1] Les figures 1A à 1C représentent différentes étapes d'un procédé de pilotage d'un transistor selon l'état de la technique ;
[Fig 2] la figure 2 est un graphe temporel représentant l'évolution de la tension entre la grille et l'émetteur du transistor au cours de la mise en œuvre du procédé des figures 1A à 1C ;
[Fig 3] Les figures 3A à 3C représentent différentes étapes d'un procédé de pilotage d'un transistor selon l'invention ; et,
[Fig 4] la figure 4 est un graphe temporel représentant l'évolution de la tension entre la grille et l'émetteur du transistor au cours de la mise en œuvre du procédé des figures 3A à 3C

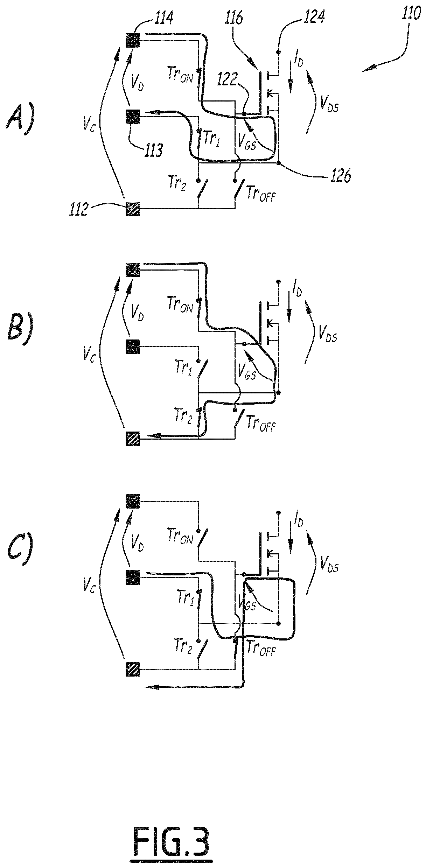

Le circuit 110, représenté à la figure 3, comporte un transistor 116 en tant que composant de puissance à grille isolée. Il s'agit de préférence d'un transistor du type MOSFET, mais il pourrait en variante s'agir de tout type de transistor à grille isolée et notamment d'un transistor du type IGBT (les noms des bornes du transistor - grille, drain, source - seraient alors différents, au moins pour certaines des bornes du transistor, dans le texte ci-dessous mais le fonctionnement serait analogue).

Le transistor 116 comporte une grille 122, qui est connectée :
- via un premier interrupteur TrON, à un premier point 114 porté à un premier potentiel V1 (par exemple égal à +15 V) tel que la différence de potentiels entre ce premier point et un point de référence 113 corresponde à une première tension VD positive et supérieure à un seuil de conduction du transistor 116 au-delà duquel se dernier devient passant (seuil de conduction qui est une caractéristique prédéfinie du transistor 116) ; et,
- via un second interrupteur TrOFF, à un second point 112 porté à un second potentiel V2 (par exemple égal à -5 V) tel que la différence de potentiels entre le premier point et ce second point corresponde à une seconde tension VC positive et supérieure à la première tension VD.

Par ailleurs, la source 126 du transistor 116 est connectée :
- via un troisième interrupteur Tr1, au point de référence 113 porté à un troisième potentiel V3 (par exemple égal à +0V) ; et,
- via un quatrième interrupteur Tr2, au second point 112.

Enfin, le drain 124 du transistor 116 est relié à une charge (non représentée sur les figures).

Dans une étape, représentée à la figure 3A, d'amorçage du basculement du transistor 116 dans l'état passant (« ON »), c'est-à-dire de commande du transistor de l'état boquant/bloqué vers l'état passant, les interrupteurs TrOFF et Tr2 sont ouverts, tandis que les interrupteurs TrON et Tr1 sont fermés, de sorte que la source 126 soit au potentiel du point de référence 113 et la grille 122 au potentiel du premier point 114. La tension VGS entre la source et la grille est alors égale à la première tension VD, VD=V1-V3 (égale à +15V selon les exemples numériques précédents).

Dans une étape, représentée à la figure 3B, de basculement définitif du transistor 116 dans l'état passant (« ON »), c'est-à-dire de maintien du transistor 116 dans l'état passant, les interrupteurs TrOFF et Tr1 sont ouverts, tandis que les interrupteurs TrON et Tr2 sont fermés, de sorte que la source 126 soit au potentiel du second point 112 et la grille 122 au potentiel du premier point 114. La tension VGE entre la source et la grille est alors égale à la seconde tension VC, VC=V1-V2 (égale à +20V selon les exemples numériques précédents).

Enfin, dans une étape, représentée à la figure 3C, de basculement du transistor 116 dans l'état bloquant (« OFF »), c'est-à-dire de commande du transistor de l'état passant vers l'état boquant/bloqué, les interrupteurs TrON et Tr2 sont ouverts, tandis que les interrupteurs TrOFF et Tr1 sont fermés, de sorte que la source 126 soit au potentiel du point de référence 113 et la grille 122 au potentiel du second point 112. La tension VGE entre la source et la grille est alors égale à une troisième tension VOFF, qui est une tension négative correspondant à la différence entre la première tension VD et la seconde tension VC : VOFF= VD-VC=V2-V3 (égale à -5V selon les exemples numériques précédents).

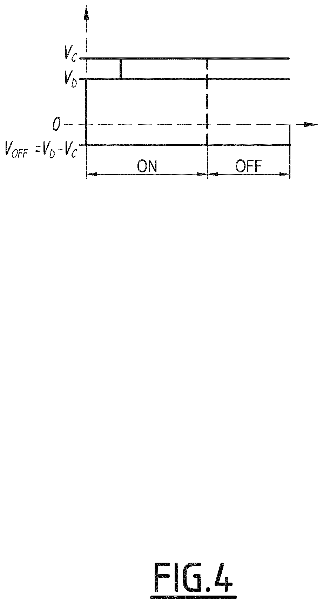

La figure 4 résume ces différentes étapes de pilotage du transistor 116 en représentant la tension VGS au cours du temps : la première tension VD est appliquée pendant une période d'amorçage courte, avant l'application de la seconde tension VC, pour établir l'état passant ; puis la tension VGS est fixée à la troisième tension VOFF pour établir l'état bloquant.

Le procédé selon l'invention consiste donc à basculer le composant de puissance dans l'état passant en deux étapes successives, un amorçage du basculement avec une tension intermédiaire, avant l'application d'une tension finale plus élevée. Le procédé selon l'invention consiste également à basculer le composant de puissance dans l'état bloquant par application d'une tension négative.

En variante, le basculement dans l'état bloquant pourrait également se faire en deux étapes successives. Dans ce cas, l'établissement de l'état bloquant consistant à :
- amorcer l'état bloquant par application d'une première tension de blocage, ladite première tension de blocage étant inférieure au seuil de conduction du composant de puissance, supérieure à la troisième tension VOFF et appliquée pendant une durée d'amorçage du blocage (qui peut être choisie d'une durée différente de la durée d'amorçage de l'état passant) ; puis,
- maintenir l'état bloquant par application de la troisième tension VOFF.

Pour l'établissement dans l'état passant, l'amorçage a pour effet d'améliorer la robustesse en cas de circulation d'un courant important entre le collecteur et l'émetteur du transistor 116, courant causé par un court-circuit dans le dispositif intégrant le circuit 110. Si aucun court-circuit n'est détecté, alors, dans un second temps, la tension finale, plus élevée, est appliquée pour réduire les pertes par conduction à l'intérieur du transistor 116 dans l'état passant.

En effet, pour réduire les pertes par conduction dans les composants de puissance à grille isolée placés dans l'état passant, on doit appliquer une tension sur la grille la plus élevée possible. L'inconvénient est que plus cette tension est élevée moins le composant est robuste aux courants de court-circuit. En limitant les pertes, on dégrade donc la qualité de la protection aux courts-circuits.

Ainsi pour un transistor MOSFET en technologie SiC, il est courant de devoir appliquer 20V de tension sur la grille (au lieu de 15V pour les composants Si (silicium) conventionnels) pour atteindre le niveau réduit de pertes caractérisant ce type de composants. La conséquence est de réduire la durée d'un court-circuit supportable par le transistor à environ 2µs. Le risque de dégradation du composant par un courant de court-circuit est par conséquent accru.

Le procédé selon l'invention permet donc de garder les pertes par conduction à un niveau faible, en utilisant une seconde tension élevée, tout en augmentant la robustesse au court-circuit en initiant l'état passant avec une première tension plus faible. C'est cette première tension qui sera en jeu en cas de circulation à travers le composant d'un courant important de court-circuit.

Par exemple, dans un dispositif du type allumeur intégrant le circuit 110, lorsqu'un court-circuit est présent au moment où le composant de puissance est basculé dans l'état passant, le système de détection/protection contre les courts-circuits du dispositif détecte la présence du court-circuit et commande le blocage du composant de puissance et le maintien dans l'état passant par application d'un second niveau de tension n'est pas exécuté. La durée d'amorçage doit donc être choisie de manière à permettre à ce système de détection/protection de jouer son rôle. La tension d'amorçage est choisie pour que la puissance dissipée pendant la période d'amorçage soit compatible des caractéristiques de résistance aux courts-circuits du composant de puissance utilisé.

Pour le basculement dans l'état bloquant, que la tension VOFF soit négative a pour effet de sécuriser l'état du composant de puissance en l'immunisant contre les perturbations, notamment les perturbations risquant de conduire au basculement du composant de puissance dans l'état passant.

Ceci est plus particulièrement intéressant pour des composants de puissance à commutation rapide utilisés dans des applications de forte puissance, comme par exemple les transistors du type MOSFET, en particulier ceux en technologie SiC.

Il est à noter que les figures 3 représentent un mode de réalisation du circuit selon l'invention à un niveau fonctionnel. L'homme du métier sait comment élaborer un circuit physique correspondant à ce circuit fonctionnel, notamment en sélectionnant et agençant des composants électroniques de manière à définir les potentiels des premier point, second point et point de référence, ainsi que pour réaliser les interrupteurs et les moyens pour en commander l'ouverture et la fermeture.

## Revendications

1. Procédé de pilotage d'un composant de puissance à grille isolée du type transistor (116) propre à être commandé entre un état passant et un état bloquant, comportant les étapes consistant à :
- amorcer l'état passant par application, pendant une durée d'amorçage, d'une première tension (VD), ladite première tension étant une tension positive, supérieure à un seuil de conduction du composant de puissance ; puis,
- maintenir l'état passant par application d'une seconde tension (VC), ladite seconde tension étant une tension positive, supérieure à la première tension,
- établir l'état bloquant en appliquant une troisième tension (VOFF), ladite troisième tension étant strictement négative,
**caractérisé en ce que**, une grille (122) du composant de puissance (116) étant connectée:
- via un premier interrupteur (TrON), à un premier point (114) porté à un premier potentiel tel que la différence de potentiels entre le premier point et un point de référence (113) corresponde à la première tension (VD),
et une source (126) du composant de puissance étant connectée:
- via un troisième interrupteur (Tr1), au point de référence (113) porté à un troisième potentiel ; et,
- via un quatrième interrupteur (Tr2), à un deuxième point (112) porté à un deuxième potentiel tel que la différence de potentiels entre le premier point et le deuxième point corresponde à la seconde tension (VC),
lors de l'étape d'amorçage, les premier et troisième interrupteurs sont commandés dans l'état fermé tandis que le quatrième interrupteur est commandé dans l'état ouvert,
et lors de l'étape de maintien dans l'état passant, les premier et quatrième interrupteurs sont commandés dans l'état fermé tandis que le troisième interrupteur est commandé dans l'état ouvert.

2. Procédé selon la revendication 1, dans lequel le composant de puissance à grille isolée du type transistor est du type MOSFET, en particulier du type MOSFET en technologie SiC.

3. Procédé selon la revendication 1 ou la revendication 2, dans lequel la grille (122) du composant de puissance (116) est connectée via un deuxième interrupteur (TrOFF), à un troisième point (112) porté à un quatrième potentiel tel que la différence de potentiels entre le troisième point et le point de référence est égale à la troisième tension,
et dans lequel lors de l'étape d'établissement de l'état bloquant, le deuxième interrupteur et le troisième interrupteur sont commandés dans l'état fermé, tandis que les premier et quatrième interrupteurs sont commandés dans l'état ouvert.

4. Procédé selon la revendication 3, dans lequel le deuxième potentiel et le quatrième potentiel sont égaux, les deuxième et troisième points étant confondus, et dans lequel, lors des étapes d'amorçage et de maintien dans l'état passant, le deuxième interrupteur est commandé dans l'état ouvert.

5. Circuit de pilotage d'un composant de puissance à grille isolée du type transistor (116) pour la mise en œuvre d'un procédé de pilotage conforme à l'une quelconque des revendications précédentes, ledit circuit étant **caractérisé en ce qu'**il comprend un premier, un troisième et un quatrième interrupteur,
le premier interrupteur étant propre à connecter une grille (122) du composant de puissance (116) à un premier point (114) porté à un premier potentiel tel que la différence de potentiels entre le premier point et un point de référence (113) du circuit de pilotage corresponde à une première tension (VD) ;
le troisième interrupteur (Tr1) étant propre à connecter une source (126) du composant de puissance au point de référence (113) porté à un troisième potentiel ; et,
le quatrième interrupteur (Tr2) étant propre à connecter la source (126) à un deuxième point (112), porté à un deuxième potentiel tel que la différence de potentiels entre le premier point et le deuxième point corresponde à une seconde tension (VC).

6. Circuit de pilotage selon la revendication 5, ledit circuit étant **caractérisé en ce qu'**il comprend un deuxième interrupteur (TrOFF), le deuxième interrupteur étant propre à connecter la grille (122) du composant de puissance (116) à un troisième point (112) porté à un quatrième potentiel tel que la différence de potentiels entre le troisième point et le point de référence est égale à la troisième tension.

7. Dispositif de puissance, **caractérisé en ce qu'**il comporte au moins un composant de puissance à grille isolée du type transistor (116) piloté par un circuit de pilotage conforme à l'une quelconque des revendications 5 à 6.

## Patentansprüche

1. Verfahren zum Steuern einer Leistungskomponente mit isoliertem Gate vom Transistortyp (116), welche imstande ist, zwischen einem Durchlassen-Zustand und einem Sperren-Zustand gesteuert zu werden, welches die Schritte aufweist, bestehend aus:
- Beginnen des Durchlassen-Zustands mittels Anlegens, während einer Beginnen-Dauer, einer ersten Spannung (VD), wobei die besagte erste Spannung eine positive Spannung ist, welche höher ist als ein Leitung-Schwellwert der Leistungskomponente, dann
- Beibehalten des Durchlassen-Zustands mittels Anlegens einer zweiten Spannung (VC), wobei die besagte zweite Spannung eine positive Spannung ist, welche höher als die erste Spannung ist,
- Herstellen des Sperren-Zustands mittels Anlegens einer dritten Spannung (VOFF), wobei die besagte dritte Spannung streng negativ ist,
**dadurch gekennzeichnet, dass** ein Gate (122) der Leistungskomponente (116) verbunden ist:
- via einen ersten Unterbrecher (TrON) mit einem ersten Punkt (114), welcher auf ein erstes Potential gebracht ist, sodass die Potentialdifferenz zwischen dem ersten Punkt und einem Referenzpunkt (113) zur ersten Spannung (VD) korrespondiert,
und eine Source (126) der Leistungskomponente verbunden ist:
- via einen dritten Unterbrecher (Tr1) mit dem Referenzpunkt (113), welcher auf ein drittes Potential gebracht ist, und
- via einen vierten Unterbrecher (Tr2) mit einem zweiten Punkt (112), welcher auf ein zweites Potential gebracht ist, sodass die Potenzialdifferenz zwischen dem ersten Punkt und dem zweiten Punkt zur zweiten Spannung (VC) korrespondiert,
während des Beginnen-Schrittes, der erste und der dritte Unterbrecher in den Geschlossen-Zustand gesteuert sind, während der vierte Unterbrecher in den Offen-Zustand gesteuert ist,
und, während des Schritts des Beibehaltens im Durchlassen-Zustand, der erste und der vierte Unterbrecher in den Geschlossen-Zustand gesteuert sind, während der dritte Unterbrecher in den Offen-Zustand gesteuert ist.

2. Verfahren gemäß Anspruch 1, wobei die Leistungskomponente mit isoliertem Gate vom Transistortyp vom MOSFET-Typ ist, insbesondere vom MOSFET-Typ in SiC-Technologie.

3. Verfahren gemäß Anspruch 1 oder Anspruch 2, wobei das Gate (122) der Leistungskomponente (116) via einen zweiten Unterbrecher (TrOFF) mit einem dritten Punkt (112) verbunden wird, welcher auf ein viertes Potential gebracht ist, sodass die Potentialdifferenz zwischen dem dritten Punkt und dem Referenzpunkt gleich der dritten Spannung ist,
und wobei im Schritt des Herstellens des Sperren-Zustands der zweite Unterbrecher und der dritte Unterbrecher in den Geschlossen-Zustand gesteuert sind, während der erste und der vierte Unterbrecher in den Offen-Zustand gesteuert sind.

4. Verfahren gemäß Anspruch 3, wobei das zweite Potential und das vierte Potential gleich sind, wobei der zweite und der dritte Punkt zusammenfallen, und wobei, während der Schritte des Beginnens und des Beibehaltens im Durchlassen-Zustand, der zweite Unterbrecher in den Offen-Zustand gesteuert ist.

5. Schaltkreis zum Steuern einer Leistungskomponente mit isoliertem Gate vom Transistortyp (116) für das Durchführen eines Verfahrens zum Steuern gemäß irgendeinem der vorherigen Ansprüche, wobei der besagte Schaltkreis **dadurch gekennzeichnet ist, dass** er einen ersten, einen dritten und einen vierten Unterbrecher aufweist,
wobei der erste Unterbrecher imstande ist, ein Gate (122) der Leistungskomponente (116) mit einem ersten Punkt (114), welcher auf ein erstes Potential gebracht ist, zu verbinden, sodass die Potentialdifferenz zwischen dem ersten Punkt und einem Referenzpunkt (113) des Schaltkreises zum Steuern zu einer ersten Spannung (VD) korrespondiert,
wobei der dritte Unterbrecher (Tr1) imstande ist, eine Source (126) der Leistungskomponente mit dem Referenzpunkt (113), welcher auf ein drittes Potential gebracht ist, zu verbinden, und
wobei der vierte Unterbrecher (Tr2) imstande ist, die Source (126) mit einem zweiten Punkt (112), welcher auf ein zweites Potential gebracht ist, zu verbinden, sodass die Potentialdifferenz zwischen dem ersten Punkt und dem zweiten Punkt zu einer zweiten Spannung (VC) korrespondiert.

6. Schaltkreis zum Steuern gemäß Anspruch 5, wobei der besagte Schaltkreis **dadurch gekennzeichnet ist, dass** er einen zweiten Unterbrecher (TrOFF) aufweist, wobei der zweite Unterbrecher imstande ist, das Gate (122) der Leistungskomponente (116) mit einem dritten Punkt (112), welcher auf ein viertes Potential gebracht ist, zu verbinden, sodass die Potentialdifferenz zwischen dem dritten Punkt und dem Referenzpunkt gleich der dritten Spannung ist.

7. Leistungsvorrichtung, **dadurch gekennzeichnet, dass** sie zumindest eine Leistungskomponente mit isoliertem Gate vom Transistortyp (116) aufweist, welche mittels eines Schaltkreises zum Steuern gemäß irgendeinem der Ansprüche 5 bis 6 gesteuert wird.

## Claims

1. Method for controlling a power component with insulated gate of the transistor type (116) which is able to be controlled between a passing state and a blocking state, comprising the steps consisting of:
- starting the passing state by application, during a starting time, of a first voltage (VD), said first voltage being a positive voltage, greater than a conduction threshold of the power component; then
- maintaining the passing state by application of a second voltage (VC), said second voltage being a positive voltage, greater than the first voltage,
- establishing the blocking state by applying a third voltage (VOFF), said third voltage being strictly negative,
**characterised in that**, a gate (122) of the power component (116) being connected:
- via a first switch (TrON), to a first point (114) carried at a first potential such that the difference of potentials between the first point and a reference point (113) corresponds to the first voltage (VD),
and a source (126) of the power component being connected:
- via a third switch (TR1), to the reference point (113) carried at a third potential; and
- via a fourth switch (Tr2), to a second point (112) carried at a second potential such that the difference of potentials between the first point and the second point corresponds to the second voltage (VC),
during the starting step, the first and third switches are controlled in the closed state, while the fourth switch is controlled in the open state,
and during the step of maintaining in the passing state, the first and fourth switches are controlled in the closed state, while the third switch is controlled in the open state.

2. Method according to claim 1, in which the power component with insulated gate of the transistor type is of the MOSFET type, in particular of the MOSFET type in SiC technology.

3. Method according to claim 1 or claim 2, in which the gate (122) of the power component (116) is connected via a second switch (TrOFF) to a third point (112) carried at a fourth potential such that the difference of potentials between the third point and the reference point is equal to the third voltage,
and in which, during the step of establishing the blocking state, the second switch and the third switch are controlled in the closed state, while the first and fourth switches are controlled in the open state.

4. Method according to claim 3, in which the second potential and the fourth potential are equal, the second and third points being merged, and in which, during the steps of starting and of maintaining in the passing state, the second switch is controlled in the open state.

5. Circuit for controlling a power component with insulated gate of the transistor type (116) for implementing a control method according to any of the preceding claims, said circuit being **characterised in that** it comprises a first, a third and a fourth switch,
the first switch being able to connect a gate (122) of the power component (116) to a first point (114) carried at a first potential such that the difference of potentials between the first point and a reference point (113) of the control circuit corresponds to a first voltage (VD);
the third switch (Tr1) being able to connect a source (126) of the power component to the reference point (113) carried at a third potential; and
the fourth switch (Tr2) being able to connect the source (126) to a second point (112) carried at a second voltage such that the difference of potentials between the first point and the second point corresponds to a second voltage (VC).

6. Control circuit according to claim 5, said circuit being **characterised in that** it comprises a second switch (TrOFF), the second switch being able to connect the gate (122) of the power component (116) to a third point (112) carried at a fourth potential such that the difference of potentials between the third point and the reference point is equal to the third voltage.

7. Power device, **characterised in that** it comprises at least one power component with insulated gate of the transistor type (116) controlled by a control circuit according to any of claims 5 to 6.
